# EUROPEAN PATENT SPECIFICATION

(11) **EP 2 761 677 B1**
(45) Date of publication and mention of the grant of the patent: **21.08.2019**
(21) Application number: 12787547.4
(22) Date of filing: 28.09.2012
(51) Int. Cl.: H01L 33/00

(54) **LIGHT EMITTING DIODE FABRICATED BY EPITAXIAL LIFT-OFF**
DURCH EIN EPITAKTISCHES LIFT-OFF-VERFAHREN HERGESTELLTE LICHTEMITTIERENDE DIODE
DIODE ÉLECTROLUMINESCENTE FABRIQUÉE PAR DÉCOLLEMENT ÉPITAXIAL

(30) Priority: 30.09.2011 US 201161541896 P
(43) Date of publication of application: 06.08.2014
(73) Proprietor: Microlink Devices, Inc., Niles, IL 60714 (US)
(72) Inventor: PAN, Noren, Wilmette, IL 60091 (US); ELARDE, Victor, C., Chicago, IL 60625 (US); YOUTSEY, Christopher, Libertyville, IL 60048 (US); OSOWSKI, Mark, Vernon Hills, IL 60061 (US)
(74) Representative: Nordmeyer, Philipp Werner
(86) International application number: PCT/US2012/057986
(87) International publication number: WO 2013/049614

(56) References cited:
- EP-A2- 2 302 705
- WO-A1-2010/020077
- WO-A1-2010/132552
- WO-A2-2006/116030
- US-A1- 2011 124 139

## Description

### 1. Field of Invention

Embodiments of the invention relate generally to semiconductor light emitting diodes (LEDs), and more particularly, to a LED fabricated on a substrate, where the substrate is subsequently removed from the LED in a non-destructive manner using an epitaxial lift-off (ELO) technique.

### 2. Description of Related Art

III-V semiconductor devices are conventionally formed by first growing the active layers of the device, comprising a variety of materials in various combinations, on a bulk semiconductor substrate by metal-organic chemical vapor deposition (MOCVD) or molecular beam epitaxy (MBE). The substrate provides a crystal template (e.g., GaAs or InP) consisting of a highly periodic arrangement of atoms on which the active layers are grown. The substrate does not contribute to the operation of the device. The substrate either remains as part of the final device or is removed during fabrication, leaving the active layers attached to some other structure, or handle, which provides at least partial mechanical stability. Most commonly, the substrate is removed through a combination of mechanical grinding and chemical etching. The substrate is thus effectively removed, but destroyed in the process.

US 2011/0124139 A1 describes a method for manufacturing a free-standing substrate and a free-standing light emitting device. WO 2006/116030 A2 describes a bonded intermediate substrate and a method of making the same.

### SUMMARY

The invention includes a method as defined in claim 1, a thin film III-V semiconductor light emitting diode as defined in claim 7 and a III-V semiconductor stack as defined in claim 11. The dependent claims as well as the following description provide preferred and optional embodiments.

Example embodiments described herein include, but are not limited to, methods for fabricating thin film light emitting diode structures using epitaxial lift-off, and thin film light emitting diode structures produced using epitaxial lift-off.

An embodiment of a method of fabricating a thin film light emitting diode using an epitaxial lift-off process includes forming a sacrificial layer on a substrate and forming a light emitting diode structure on the sacrificial layer by epitaxial deposition. The method also includes forming a light reflecting layer on the light emitting diode structure. The method further includes removing the sacrificial layer from the substrate using an etching process to separate the substrate from the light emitting diode structure.

In some embodiments, the method further includes forming a first contact layer on the sacrificial layer. The method may further include forming a first cladding layer on the first contact layer, forming a multiple quantum well active layer on the first cladding layer, and forming a second cladding layer on the multiple quantum well active layer. The method may also include forming a second contact layer on the second cladding layer.

In some embodiments, the method also includes attaching a handle to the light-reflecting layer prior to removing the sacrificial layer.

In some embodiments, the method also includes dicing the light emitting diode structure and the light reflecting layer subsequent to removing the sacrificial layer to form a plurality of light emitting diodes.

In some embodiments, forming the light emitting diode structure includes forming a III-V semiconductor light emitting diode structure. In some embodiments, the substrate has a diameter in the range of approximately 3 inches to approximately 12 inches.

In some embodiments, after fabrication of a first light emitting diode, the method further includes fabricating one or more additional thin film light emitting diodes using the substrate. In some embodiments, the method includes receiving a substrate previously used to form a thin film light emitting diode using an epitaxial lift-off process, and using the substrate to form an additional thin film light emitting diode.

Another embodiment is a thin film III-V semiconductor light emitting diode free of a substrate, the light emitting diode includes a first contact layer and a first cladding layer formed over the first contact layer. The light emitting diode further includes a multiple quantum well active layer formed over the first cladding layer. The light emitting diode also includes a second cladding layer formed over the multiple quantum well active layer, a second contact layer formed over the second cladding layer, and a light reflecting layer formed over the second contact layer.

In some embodiments, the light-reflecting layer includes a metallic layer. In some embodiments, the light-reflecting layer includes at least one layer of dielectric material.

In some embodiments, the light emitting diode further includes a handle coupled to the light-reflecting layer. In some embodiments, the handle includes a metal, a polymer, or both. In some embodiments, the handle is in the range of approximately 5 µm to approximately 50 µm thick.

In some embodiments, the handle is permanently coupled to the light reflecting layer.

Another embodiment includes a III-V semiconductor stack for forming a thin film light emitting diode using epitaxial lift-off. The stack includes a substrate and a sacrificial layer formed over the substrate. The stack also includes an LED structure formed over the sacrificial layer, a light reflecting layer formed over the LED structure, and a handle attached to the light reflecting layer.

In some embodiments, the light-reflecting layer includes a metallic layer. In some embodiments, the substrate has a diameter in the range of between approximately 3 inches and approximately 12 inches. In some embodiments, the LED structure includes a first contact layer formed over the sacrificial layer, a first cladding layer formed over the first contact layer, and a multiple quantum well active layer formed over the first cladding layer. The LED structure also includes a second cladding layer formed over the multiple quantum well active layer, and a second contact layer formed over the second cladding layer. In some embodiments, the first contact layer and the second contact layer are more heavily doped than the first cladding layer and the second cladding layer.

In some embodiments, the sacrificial layer includes an AlGaAs material.

The summary above is provided merely to introduce a selection of concepts that are further described below in the detailed description. The summary is not intended to identify key or essential features of the claimed subject matter, nor is it intended to be used as an aid in limiting the scope of the claimed subject matter.

### BRIEF DESCRIPTION OF THE DRAWINGS

These figures are intended to illustrate the embodiments taught herein and are not intended to show relative sizes and dimensions (e.g., they are not drawn to scale), or to limit the scope of examples or embodiments. In the drawings, each identical or nearly identical component that is illustrated in various figures is represented by a like numeral.
FIG. 1 depicts a diagrammatic representation of one example of a device structure prior to an epitaxial lift-off process in accordance with one embodiment;
FIG. 2 depicts a diagrammatic representation of one example of a device structure on a handle, and a separate substrate, after an epitaxial lift-off process in accordance with one embodiment;
FIG. 3 depicts a flow diagram of several examples of a process of fabricating a light emitting diode in accordance with one embodiment; and
FIG. 4 depicts a flow diagram of one example of a process for forming a light emitting diode structure in accordance with one embodiment.

### DETAILED DESCRIPTION

Exemplary embodiments use epitaxial lift-off (ELO) techniques during fabrication of light-emitting diodes (LEDs), and in particular, thin film LEDs free of a substrate. As discussed above, conventional fabrication techniques can destroy the substrate after the device is formed or leave the substrate in place. By contrast, an epitaxial lift-off process, in accordance with some embodiments, provides a non-destructive way of removing the substrate from a wafer of LED structures after the LED structures are formed on the wafer such that the substrate can be reused for fabricating more LEDs. For example, in some embodiments, a 4-inch wafer may accommodate between 5,000 and 20,000 LED structures. In some embodiments, a 4-inch wafer may accommodate more than 20,000 LED structures. A chemical etch can be used to remove a sacrificial release layer grown between the substrate and epitaxial layers, resulting in separation of the epitaxial layers from the substrate. The substrate remains intact and, after a re-polishing step, may be used again as the crystal template for another growth run. In some embodiments, the substrate may be reused up to ten times for forming additional epitaxial layers thereon. In some embodiments, the substrate may be reused more than ten times for forming additional thin films of LED structures. The ability to remove the epitaxially-grown layers while maintaining the integrity of the substrate is unique to the ELO process and is difficult or impossible to achieve with other known techniques.

In one embodiment, an LED fabrication process begins with epitaxially growing one or more LED structures over an epitaxial sacrificial release layer on a substrate. In some embodiments, the release layer is 8 -10 nanometers thick. In some embodiments, the epitaxial sacrificial release layer is lattice-matched to the substrate on which it is grown. The material for the sacrificial release layer has an extremely high etch rate compared with the etch rates of the other layers in the LED structure. For example, in some embodiments, a sacrificial release layer for epitaxial growth on a GaAs substrate includes high Al-content AlGaAs. A light reflecting layer and a handle may be formed over the LED structures. The handle may include one or more metals, one or more polymers, or both. After the layers and the handle are formed, the release layer is removed by an etching process, which separates the wafer of LED structures from the substrate in a manner that does not damage the substrate or the LED structures. Tensile strain provided by the handle and/or the light reflecting layer enables lift-off of the thin film layers without any external mechanical intervention: it is not necessary to add weights to the LED structure or to add Kapton or wax over the substrate or release layer for lift-off.

Each LED structure comprises transparent n- and p-type cladding layers surrounding an undoped multiple quantum well active layer, which is designed to emit light at the design wavelength of the LED. One or more light reflecting layers are deposited on the top of the wafer, which forms the back of the LED. In some embodiments, each of the one or more light reflecting layers a thickness between 10 nm and 1,000 nm. The light-reflecting layer(s) may include, for example, a metallic layer (e.g., silver) and/or multiple layers of dielectric materials. The light-reflecting layer serves at least two purposes: it forms an optical reflector to reflect light emitted by the device, as well as acting as an adhesion layer between a handle and the epitaxial layers. In some embodiments, the light-reflecting layer may provide at least some strength to the LED structure. In embodiments including a handle layer, the handle is applied to, or formed on, the light reflecting layer to provide mechanical stability to the epitaxial layers after the ELO process. In some embodiments, the handle may be formed of a material that includes copper, another similar metal, or combination of metals. In some embodiments, the handle may be formed of a material that includes a polymer, a combination of polymers, or a combination of one or more metal and one or more polymers. In some embodiments, the handle may have a thickness in the range 5 µm to 50 µm.

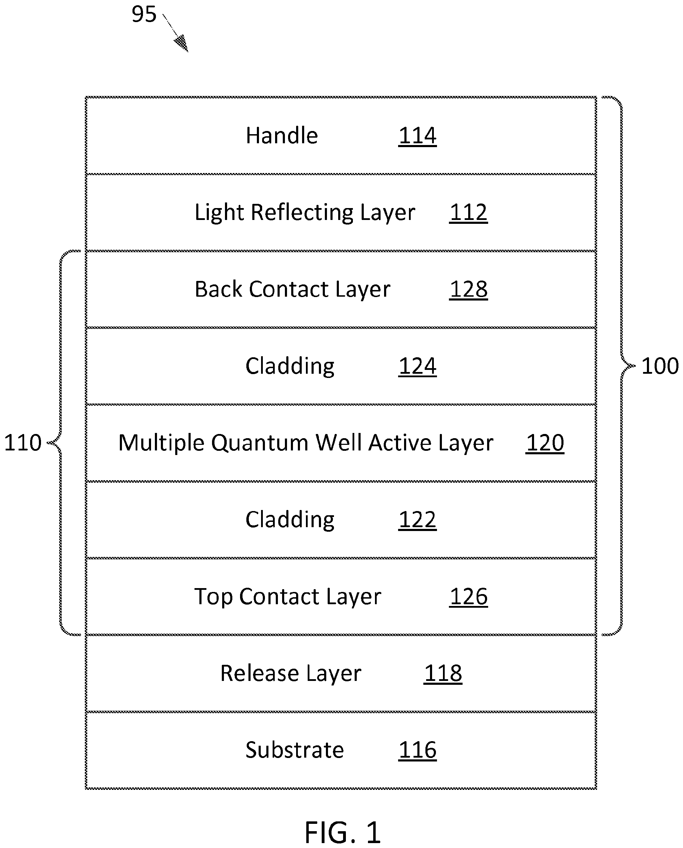

FIG. 1 depicts a diagrammatic representation of one example of a III-V semiconductor stack 95 for forming a light emitting diode device 100, according to one embodiment. The device 100 includes a light emitting diode structure 110, a light reflecting layer 112 formed on the LED structure 110, and a handle 114 attached to the light-reflecting layer 112. The semiconductor stack 95 includes a substrate 116 that supports a release layer 118 upon which the LED structure 110 is formed.

The LED structure 110 includes several epitaxial layers including a multiple quantum well (MQW) active layer 120, a first cladding layer 122 formed on one side of the MQW active layer 120, a second cladding layer 124 formed on an opposite side of the MQW active layer 120 from the first cladding layer 122, a top contact layer 126 formed on the first cladding layer 122, and a back contact layer 128 formed on the second cladding layer 124. In some embodiments, the top contact layer 126 is doped in a range of 2 x 10¹⁸ (2E18) cm⁻³ to 5E18 cm⁻³ and the back contact layer 128 is doped in a range of 2E18 cm⁻³ to 5E18 cm⁻³. The release layer 118 may be grown before any layers of the LED structure 110 are grown and formed between the substrate 116 and the top contact layer 126. The light reflecting layer 112 may be formed on the back contact layer 128 and may be configured to reflect light generated by the LED structure 110, and more particularly, light generated by the MQW active layer 120. Any of the epitaxial layers, for example, the LED structure 110, the release layer 118, the substrate 116, and/or the light reflecting layer 112, may be formed directly on an adjacent layer or indirectly over the adjacent layer with a buffer or diode in between.

The handle 114 may be affixed to or formed on the light-reflecting layer 112 to provide mechanical support for the LED structure 110 and the light-reflecting layer 112 after the device 100 is separated from the substrate 116. The handle 118 may be permanently or temporarily affixed to the light-reflecting layer 112.

After all of the epitaxial layers are grown, a chemical etch is used to remove the release layer 118, thus separating the epitaxial layers of the device 100 from the substrate 116. In some embodiments, the substrate 116 may be reused up to 10 times for fabricating additional wafers.

After the release layer 118 is removed, the LED structure 110 can be flexible because it is no longer mechanically supported by the substrate 116. In some embodiments, the back contact layer 128, the light reflecting layer 112 and/or the handle 114 have enough tensile strength to provide mechanical support to the LED structure 110 such that the integrity of the LED structure 110 is not compromised during handling after the release layer is removed 118, which can allow for high manufacturing yields. For example, some embodiments may result in a manufacturing yield of at least 90% functional devices from the deposition and lift-off process. In some embodiments, a manufacturing yield of at least 95% functional devices from the deposition and lift-off process may be attained.

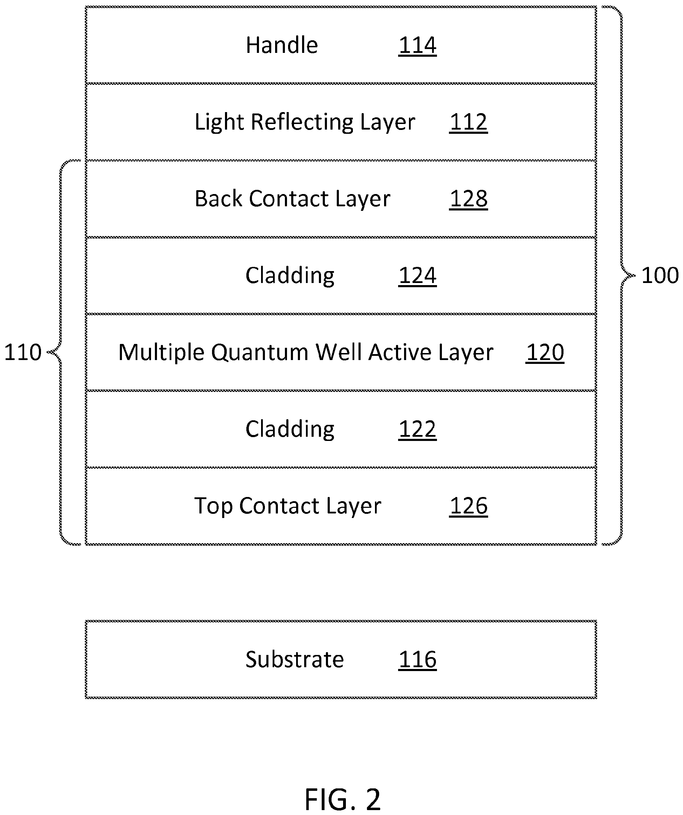

FIG. 2 depicts a diagrammatic representation of one example of the device 100 of FIG. 1, and the substrate 116, after an ELO process, according to one embodiment. After the ELO process, the release layer 118 has been removed (e.g., by etching), exposing the top contact layer 126 of the device 100 and separating the device 100, which may include the handle 114, from the substrate 116. The substrate 116 may be cleaned and re-polished to prepare it for use in another growth run. The epitaxial layers of the device 100 may be temporarily affixed to a carrier (not shown), such as a silicon substrate, a glass substrate, a sapphire substrate, or a metal substrate, using a temporary adhesive to allow further processing of the device. The carrier is useful for providing additional mechanical stability to the device because without the carrier, the device 100 may be flexible with only the handle layer 114 providing mechanical stability. The epitaxial layers of the device 100 may then be processed using, for example, conventional lithographic techniques to form multiple LED devices. After processing, the epitaxial layers of the device 100 may be removed from the carrier and diced, cut or otherwise divided into multiple individual devices, which may then be individually packaged. In some embodiments, after dividing the device into multiple individual devices, the individual devices may be from approximately 50 µm to 1,000 µm in size.

In one embodiment, a LED fabricated using an ELO process, such as described above with respect to FIGS. 1 and 2, emits light at a design wavelength when connected to an external voltage bias. The light emitting, multiple quantum well active layer 120 of the device may emit light in all directions. The light-reflecting layer 112 provides a mirror to reflect light emitted toward the back of the device and redirect it out the front. The epitaxial layers of the device 100 are inverted by the ELO process such that the device is grown with what will be the top or light emitting surface (i.e., the top contact layer 126) of the device formed at the bottom of the epitaxial layer stack, closest to the substrate 116. The first cladding layer 122 and the second cladding layer 124 confine the carriers to the active layer (e.g., the MQW active layer 120) of the device 100.

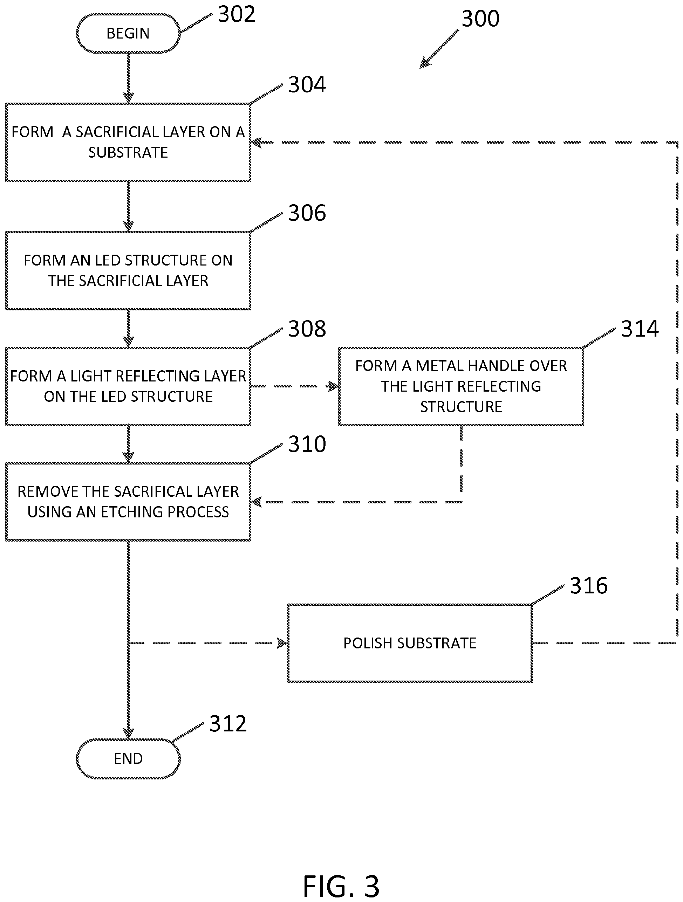

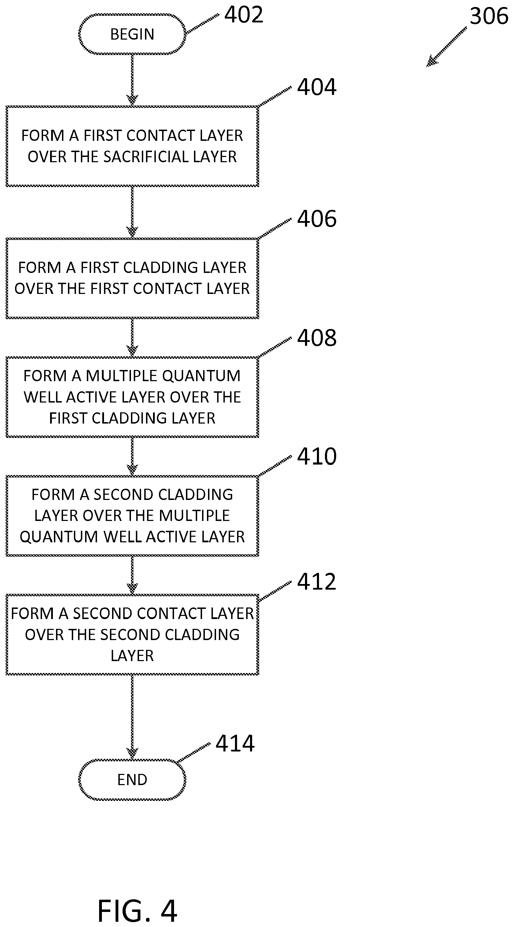

FIG. 3 depicts a flow diagram of several examples of a process 300 of fabricating a light emitting diode, according to one embodiment. The process 300 begins at step 302. At step 304, a sacrificial layer (e.g., release layer 118) is formed over a substrate (e.g., substrate 116). At step 306, a light emitting diode structure (e.g., LED structure 110) is formed over the sacrificial layer by epitaxial deposition. One example of a process for forming the light emitting diode structure is described below with respect to FIG. 4. At step 308, a light reflecting layer (e.g., light reflecting layer 112) is formed over the light emitting diode structure. At step 310, the sacrificial layer is removed from the substrate using an etching process, which separates the substrate from the light emitting diode structure. Process 300 ends at step 312. In one embodiment, the process 300 can be used to fabricate a thin film LED using one or more epitaxial materials and free of a substrate on a wafer of about 3, 4, 5, 6, 7, 8, 9, 10, 11 or 12 inches in diameter, or on a wafer having any diameter between about 3 and 12 inches.

In another embodiment, at step 314, a handle (e.g., handle 114) is affixed to or formed over the light-reflecting layer prior to removing the sacrificial layer at step 310. In yet another embodiment, at step 316, the substrate is polished and reused to fabricate another light emitting diode. In this embodiment, process 300 then returns to step 302 to repeat the fabrication process.

FIG. 4 depicts a flow diagram of one example of a process for forming a light emitting diode structure in accordance with one embodiment, such as described in step 306 of FIG. 3. The process for performing step 306 begins at step 402. At step 404, a first contact layer (e.g., top contact layer 126) is formed over the sacrificial layer. At step 406, a first cladding layer (e.g., cladding 122) is formed over the first contact layer. At step 408, a MQW active layer (e.g., MQW active layer 120) is formed over the first cladding layer. At step 410, a second cladding layer (e.g., cladding 124) is formed over the MQW active layer. At step 412, a second contact layer (e.g., back contact layer 128) is formed over the second cladding layer. The process for performing step 306 ends at step 414.

According to some embodiments, the ELO process can produce a device that is comparable to devices fabricated using a conventional substrate grinding/etching removal process. Because the substrate cost in III-V semiconductor manufacturing can be a significant component of the overall cost, the ability to reuse the substrate multiple times can provide significant cost savings. By using ELO, LEDs can be manufactured at a lower cost than possible with other manufacturing techniques through the reuse of the substrate. Further, the ELO process, according to some embodiments, can permit high manufacturing yields. Material defects resulting from the epitaxial growth, or from the ELO process, affect only the device at the location where the defect occurs. Therefore, other devices, including adjacent ones, are unaffected by such defects.

Another advantage of the ELO process is that it results in the complete removal of the substrate. In some embodiments, this allows the ELO LED to be mounted directly on a heat sink without an intervening substrate layer. Accordingly, the absence of the substrate will result in the LED operating at a lower temperature than it would if the substrate were present. Lowering the operating temperature increases LED efficiency and increases LED lifetime.

Having thus described several exemplary embodiments of the invention, it is to be appreciated that various alterations, modifications, and improvements will readily occur to those skilled in the art. For example, in some embodiments, the ELO process may be used to fabricate LED structures on large size substrates (e.g., between approximately 3- and 12-inches in diameter). In some embodiments, the ELO process may be used to fabricate a variety of LEDs, from small, low-brightness LEDs to large, high-brightness LEDs. Such alterations, modifications, and improvements are intended to be part of this disclosure, and are intended to be within the scope of the invention. Accordingly, the foregoing description and drawings are by way of example only.

## Claims

1. A method of fabricating a thin film light emitting diode (100) using an epitaxial lift-off process, the method comprising:
forming a sacrificial layer (118) on a substrate (116);
forming a light emitting diode structure (110) on the sacrificial layer (118) by epitaxial deposition;
forming a light reflecting layer (112) on the light emitting diode structure (110);
forming a metallic handle (114) on the light reflecting layer (112); and
removing the sacrificial layer (118) from the substrate (116) using an etching process to separate the substrate (116) from the light emitting diode structure (110) after forming the metallic handle (114), wherein a resulting thin film light emitting diode (100) includes the metallic handle (114).

2. The method of claim 1, wherein forming the light emitting diode structure (110) on the sacrificial layer (118) by epitaxial deposition includes:
forming a first contact layer (126) on the sacrificial layer (118);
forming a first cladding layer (122) on the first contact layer (126);
forming a multiple quantum well active layer (120) on the first cladding layer (122);
forming a second cladding layer (124) on the multiple quantum well active layer (120); and
forming a second contact layer (128) on the second cladding layer (124).

3. The method of claim 1, further comprising, after separating the substrate (116) from the light emitting diode structure (110), fabricating one or more additional thin film light emitting diodes (100) using the substrate (116).

4. The method of claim 1, wherein forming the light emitting diode structure (110) comprises forming a III-V semiconductor light emitting diode structure.

5. The method of claim 1, wherein the substrate (116) has a diameter in the range of approximately 3 inches to approximately 12 inches.

6. The method of claim 1, further comprising:
prior to forming a sacrificial layer on the substrate, receiving the substrate (116) that was previously used to form a thin film light emitting diode (100) using an epitaxial lift-off process.

7. A thin film III-V semiconductor light emitting diode free of a substrate (116), the light emitting diode comprising:
a first contact layer (126);
a first cladding layer (122) formed over the first contact layer (126);
a multiple quantum well active layer (120) formed over the first cladding layer (122);
a second cladding layer (124) formed over the multiple quantum well active layer (120);
a second contact layer (128) formed over the second cladding layer (124);
a light reflecting layer (112) formed over the second contact layer (128); and
a metallic handle (114) formed directly on the light reflecting layer (112).

8. The light emitting diode of claim 7, wherein the light-reflecting layer (112) includes a metallic layer.

9. The light emitting diode of claim 7, wherein the light-reflecting layer (112) includes at least one layer of a dielectric material.

10. The light emitting diode of claim 7, wherein a thickness of the metallic handle (114) is in a range from approximately 5 µm to approximately 50 µm.

11. A III-V semiconductor stack (95) for forming a thin film light emitting diode (100) using epitaxial lift-off, the stack comprising:
a substrate (116);
a sacrificial layer (118) formed over the substrate (116);
an LED structure (110) formed over the sacrificial layer (118);
a light reflecting layer (112) formed over the LED structure (110); and
a metallic handle (114) formed directly on the light reflecting layer (112), wherein the resulting thin film light emitting diode (100) formed from the III-V semiconductor stack (95) includes the metallic handle (114).

12. The III-V semiconductor stack (95) of claim 11, wherein the light-reflecting layer (112) includes a metallic layer.

13. The III-V semiconductor stack (95) of claim 11, wherein the substrate (116) has a diameter in the range of between approximately 3 inches and approximately 12 inches.

14. The III-V semiconductor stack (95) of claim 11, wherein the LED structure (110) comprises:
a first contact layer (126) formed over the sacrificial layer (118);
a first cladding layer (122) formed over the first contact layer (126);
a multiple quantum well active layer (120) formed over the first cladding layer (122);
a second cladding layer (124) formed over the multiple quantum well active layer (120); and
a second contact layer (128) formed over the second cladding layer (124),
wherein the first contact layer (126) and the second contact layer (128) are more heavily doped than the first cladding layer (122) and the second cladding layer (124).

15. The III-V semiconductor stack (95) of claim 11, wherein the sacrificial layer (118) comprises an AlGaAs material.

16. The method of claim 1, wherein the metallic handle (114) is formed on and in direct physical contact with the light reflecting layer (112).

17. The method of claim 1, wherein the light reflecting layer (112) is formed directly on and in direct physical contact with the light emitting diode structure (110).

18. The III-V semiconductor stack of claim 11, wherein the light reflecting layer (112) is formed directly on and in direct physical contact with the LED structure (110).

## Patentansprüche

1. Verfahren zum Herstellen einer Licht emittierenden Dünnfilmdiode (100) unter Verwenden eines epitaktischen Lift-Off-Prozesses, wobei das Verfahren Folgendes umfasst:
Bilden einer Opferschicht (118) auf einem Substrat (116);
Bilden einer Struktur (110) einer Licht emittierenden Diode auf der Opferschicht (118) durch epitaktische Abscheidung;
Bilden einer Licht reflektierenden Schicht (112) auf der Struktur (110) der Licht emittierenden Diode;
Bilden eines metallischen Griffs (114) auf der Licht reflektierenden Schicht (112); und
Entfernen der Opferschicht (118) von dem Substrat (116) unter Verwenden eines Ätzprozesses, um das Substrat (116) von der Struktur (110) der Licht emittierenden Diode zu trennen, nachdem der metallische Griff (114) gebildet wurde, wobei eine resultierende Licht emittierende Dünnfilmdiode (100) den metallischen Griff (114) aufweist.

2. Verfahren nach Anspruch 1, wobei das Bilden der Struktur (110) der Licht emittierenden Diode auf der Opferschicht (118) durch epitaktisches Abscheiden Folgendes aufweist:
Bilden einer ersten Kontaktschicht (126) auf der Opferschicht (118);
Bilden einer ersten Mantelschicht (122) auf der ersten Kontaktschicht (126);
Bilden einer mehrfachen aktiven Quantentopfschicht (120) auf der ersten Mantelschicht (122);
Bilden einer zweiten Mantelschicht (124) auf der mehrfachen aktiven Quantentopfschicht (120);
und
Bilden einer zweiten Kontaktschicht (128) auf der zweiten Mantelschicht (124).

3. Verfahren nach Anspruch 1, das weiter nach dem Trennen des Substrats (116) von der Struktur (110) der Licht emittierenden Diode das Herstellen einer oder mehrerer zusätzlicher Licht emittierender Dünnfilmdioden (100) unter Verwenden des Substrats (116) umfasst.

4. Verfahren nach Anspruch 1, wobei das Bilden der Struktur (110) der Licht emittierenden Diode das Bilden einer Struktur einer Licht emittierenden III-V-Halbleiterdiode umfasst.

5. Verfahren nach Anspruch 1, wobei das Substrat (116) einen Durchmesser in dem Bereich von etwa 3 Zoll bis etwa 12 Zoll hat.

6. Verfahren nach Anspruch 1, das weiter Folgendes umfasst:
vor dem Bilden einer Opferschicht auf dem Substrat, Empfangen des Substrats (116), das zuvor verwendet wurde, um eine Licht emittierende Dünnfilmdiode (100) unter Verwenden eines epitaktischen Lift-Off-Prozesses zu bilden,

7. Licht emittierende Dünnfilm-III-V-Halbleiterdiode frei von einem Substrat (116), wobei die Licht emittierende Diode Folgendes umfasst:
eine erste Kontaktschicht (126);
eine erste Mantelschicht (122), die über der ersten Kontaktschicht (126) gebildet ist;
eine mehrfache aktive Quantentopfschicht (120), die über der ersten Mantelschicht (122) gebildet ist;
eine zweite Mantelschicht (124), die über der mehrfachen aktiven Quantentopfschicht (120) gebildet ist;
eine zweite Kontaktschicht (128), die über der zweiten Mantelschicht (124) gebildet ist;
eine Licht reflektierende Schicht (112), die über der zweiten Kontaktschicht (128) gebildet ist; und
einen metallischen Griff (114), der direkt auf der Licht reflektierenden Schicht (112) gebildet ist.

8. Licht emittierende Diode nach Anspruch 7, wobei die Licht reflektierende Schicht (112) eine metallische Schicht aufweist.

9. Licht emittierende Diode nach Anspruch 7, wobei die Licht reflektierende Schicht (112) mindestens eine metallische Schicht aus einem dielektrischen Material aufweist.

10. Licht emittierende Diode nach Anspruch 7, wobei eine Stärke des metallischen Griffs (114) in einem Bereich von etwa 5 µm bis etwa 50 µm liegt.

11. III-V-Halbleiterstapel (95) zum Bilden einer Licht emittierenden Dünnfilmdiode (100) unter epitaktischem Lift-Off, wobei der Stapel Folgendes umfasst:
ein Substrat (116);
eine Opferschicht (118), die über dem Substrat (116) gebildet ist;
eine LED-Struktur (110), die über der Opferschicht (118) gebildet ist;
eine Licht reflektierende Schicht (112), die über der LED-Struktur (110) gebildet ist; und
einen metallischen Griff (114), der direkt auf der Licht reflektierenden Schicht (112) gebildet ist, wobei die resultierende Licht emittierende Dünnfilmdiode (100), die von dem III-V-Halbleiterstapel (95) gebildet wird, den metallischen Griff (114) aufweist.

12. III-V-Halbleiterstapel (95) nach Anspruch 11, wobei die Licht reflektierende Schicht (112) eine metallische Schicht aufweist.

13. III-V-Halbleiterstapel (95) nach Anspruch 11, wobei das Substrat (116) einen Durchmesser in dem Bereich von zwischen etwa 3 Zoll und etwa 12 Zoll hat.

14. III-V-Halbleiterstapel (95) nach Anspruch 11, wobei die LED-Struktur (110) Folgendes umfasst:
eine erste Kontaktschicht (126), die über der Opferschicht (118) gebildet ist;
eine erste Mantelschicht (122), die über der ersten Kontaktschicht (126) gebildet ist;
eine mehrfache aktive Quantentopfschicht (120), die über der ersten Mantelschicht (122) gebildet ist;
eine zweite Mantelschicht (124), die über der mehrfachen aktiven Quantentopfschicht (120) gebildet ist;
und
eine zweite Kontaktschicht (128), die über der zweiten Mantelschicht (124) gebildet ist;
wobei die erste Kontaktschicht (126) und die zweite Kontaktschicht (128) stärker dotiert sind als die erste Mantelschicht (122) und die zweite Mantelschicht (124).

15. III-V-Halbleiterstapel (95) nach Anspruch 11, wobei die Opferschicht (118) AlGaAs-Material umfasst.

16. Verfahren nach Anspruch 1, wobei der metallische Griff (114) auf und in direktem physischem Kontakt mit der Licht reflektierenden Schicht (112) gebildet ist.

17. Verfahren nach Anspruch 1, wobei die Licht reflektierende Schicht (112) direkt auf und in direktem physischem Kontakt mit der Struktur (110) der Licht emittierenden Diode gebildet ist.

18. III-V-Halbleiterstapel nach Anspruch 11, wobei die Licht reflektierende Schicht (112) direkt auf und in direktem physischem Kontakt mit der LED-Struktur (110) gebildet ist.

## Revendications

1. Procédé de fabrication d'une diode électroluminescente à film mince (100) en utilisant un processus de décollement épitaxial, le procédé comprenant :
la formation d'une couche sacrificielle (118) sur un substrat (116) ;
la formation d'une structure de diode électroluminescente (110) sur la couche sacrificielle (118) par dépôt épitaxial ;
la formation d'une couche réfléchissant la lumière (112) sur la structure de diode électroluminescente (110) ;
la formation d'un manche métallique (114) sur la couche réfléchissant la lumière (112) ; et
le retrait de la couche sacrificielle (118) du substrat (116) en utilisant un processus de gravure pour séparer le substrat (116) de la structure de diode électroluminescente (110) après la formation du manche métallique (114), dans lequel une diode électroluminescente à film mince résultante (100) inclut le manche métallique (114).

2. Procédé selon la revendication 1, dans lequel la formation de la structure de diode électroluminescente (110) sur la couche sacrificielle (118) par dépôt épitaxial inclut :
la formation d'une première couche de contact (126) sur la couche sacrificielle (118) ;
la formation d'une première couche de revêtement (122) sur la première couche de contact (126) ;
la formation d'une multiple couche active à puits quantique (120) sur la première couche de revêtement (122) ;
la formation d'une seconde couche de revêtement (124) sur la multiple couche active à puits quantique (120) ; et
la formation d'une seconde couche de contact (128) sur la seconde couche de revêtement (124).

3. Procédé selon la revendication 1, comprenant en outre, après la séparation du substrat (116) de la structure de diode électroluminescente (110), la fabrication des une ou plusieurs diodes électroluminescentes à film mince supplémentaires (100) en utilisant le substrat (116).

4. Procédé selon la revendication 1, dans lequel la formation de la structure de diode électroluminescente (110) comprend la formation d'une structure de diode électroluminescente à semi-conducteur III-V.

5. Procédé selon la revendication 1, dans lequel le substrat (116) présente un diamètre dans la plage d'approximativement 3 pouces à approximativement 12 pouces.

6. Procédé selon la revendication 1, comprenant en outre :
avant la formation d'une couche sacrificielle sur le substrat, la réception du substrat (116) qui a été précédemment utilisé pour former une diode électroluminescente à film mince (100) en utilisant un processus de décollement épitaxial.

7. Diode électroluminescente à semi-conducteur III-V à film mince exempte d'un substrat (116), la diode électroluminescente comprenant :
une première couche de contact (126) ;
une première couche de revêtement (122) formée sur la première couche de contact (126) ;
une multiple couche active à puits quantique (120) formée sur la première couche de revêtement (122) ;
une seconde couche de revêtement (124) formée sur la multiple couche active à puits quantique (120) ;
une seconde couche de contact (128) formée sur la seconde couche de revêtement (124) ;
une couche réfléchissant la lumière (112) formée sur la seconde couche de contact (128) ; et
un manche métallique (114) formé directement sur la couche réfléchissant la lumière (112).

8. Diode électroluminescente selon la revendication 7, dans laquelle la couche réfléchissant la lumière (112) inclut une couche métallique.

9. Diode électroluminescente selon la revendication 7, dans lequel la couche réfléchissant la lumière (112) inclut au moins une couche d'un matériau diélectrique.

10. Diode électroluminescente selon la revendication 7, dans lequel une épaisseur du manche métallique (114) est dans une plage d'approximativement 5 µm à approximativement 50 µm.

11. Pile de semi-conducteur III-V (95) pour la formation d'une diode électroluminescente à film mince (100) en utilisant un décollement épitaxial, la pile comprenant :
un substrat (116) ;
une couche sacrificielle (118) formée sur le substrat (116) ;
une structure LED (110) formée sur la couche sacrificielle (118) ;
une couche réfléchissant la lumière (112) formée sur la structure LED (110) ; et
un manche métallique (114) formé directement sur la couche réfléchissant la lumière (112), dans laquelle la diode électroluminescente à film mince résultante (100) formée à partir de la pile de semi-conducteur III-V (95) inclut le manche métallique (114).

12. Pile de semi-conducteur III-V (95) selon la revendication 11, dans laquelle la couche réfléchissant la lumière (112) inclut une couche métallique.

13. Pile de semi-conducteur III-V (95) selon la revendication 11, dans laquelle le substrat (116) présente un diamètre dans la plage entre approximativement 3 pouces et approximativement 12 pouces.

14. Pile de semi-conducteur III-V (95) selon la revendication 11, dans laquelle la structure LED (110) comprend :
une première couche de contact (126) formée sur la couche sacrificielle (118) ;
une première couche de revêtement (122) formée sur la première couche de contact (126) ;
une multiple couche active à puits quantique (120) formée sur la première couche de revêtement (122) ;
une seconde couche de revêtement (124) formée sur la multiple couche active à puits quantique (120) ; et
une seconde couche de contact (128) formée sur la seconde couche de revêtement (124),
dans laquelle la première couche de contact (126) et la seconde couche de contact (128) sont plus lourdement dopées que la première couche de revêtement (122) et la seconde couche de revêtement (124).

15. Pile de semi-conducteur III-V (95) selon la revendication 11, dans laquelle la couche sacrificielle (118) comprend un matériau AlGaAs.

16. Procédé selon la revendication 1, dans laquelle le manche métallique (114) est formé sur la couche réfléchissant la lumière (112) et en contact physique direct avec celle-ci.

17. Procédé selon la revendication 1, dans laquelle la couche réfléchissant la lumière (112) est formée directement sur la structure de diode électroluminescente (110) et en contact physique direct avec celle-ci.

18. Pile de semi-conducteur III-V selon la revendication 11, dans laquelle la couche réfléchissant la lumière (112) est formée directement sur la structure LED (110) et en contact physique direct avec celle-ci.
